# FASCICULE DE BREVET EUROPEEN

(11) **EP 3 938 792 B1**
(45) Date de publication et mention de la délivrance du brevet: **07.06.2023**
(21) Numéro de dépôt: 20713352.1
(22) Date de dépôt: 21.02.2020
(51) Int. Cl.: H02H 3/04, G01R 31/00, G01R 31/54, H02H 3/10

(54) **INSTALLATION ELECTRIQUE COMPORTANT UN MODULE DE SURVEILLANCE**
ELEKTRISCHE ANLAGE MIT EINEM ÜBERWACHUNGSMODUL
ELECTRICAL INSTALLATION COMPRISING A MONITORING MODULE

(30) Priorité: 11.03.2019 FR 1902470
(43) Date de publication de la demande: 19.01.2022
(73) Titulaire: Crouzet Automatismes, 26000 Valence (FR)
(72) Inventeur: CARTON, Hervé, 26000 Valence (FR); STEMMELEN, Thomas, 26000 Valence (FR); CLÉMENSON, Loic, 26000 Valence (FR)
(74) Mandataire: INNOV-GROUP
(86) Numéro de dépôt international: PCT/FR2020/050331
(87) Numéro de publication internationale: WO 2020/183083

(56) Documents cités:
- EP-A1- 3 413 064
- JP-U- 3 150 794
- US-A1- 2005 018 371

## Description

L'invention concerne une installation électrique comportant un module de surveillance. L'invention concerne aussi un aéronef comportant cette installation électrique ainsi qu'un module de surveillance pour cette installation électrique.

Le déposant connaît une telle installation électrique comportant :
- un premier et un second câbles d'alimentation raccordés, respectivement, à un premier et un second potentiels différents d'une source d'alimentation,
- un câble de mesure, les premier et second câbles d'alimentation et le câble de mesure étant logés à l'intérieur d'un ou plusieurs harnais de câbles,
- un capteur apte à mesurer une grandeur physique, ce capteur comportant :
   - une première et une seconde bornes d'alimentation raccordées, respectivement, au premier et au second câbles d'alimentation,
   - une borne de sortie raccordée au câble de mesure, et
   - un transducteur alimenté par l'intermédiaire des première et seconde bornes d'alimentation du capteur, ce transducteur étant apte à transformer la grandeur physique mesurée en un signal électrique correspondant, et
   - le capteur est apte à délivrer, sur sa borne de sortie, un signal électrique analogique codant la mesure de la grandeur physique par une valeur correspondante d'un potentiel ou de l'intensité d'un courant, la valeur du signal électrique délivré sur le câble de mesure étant systématiquement comprise dans une plage prédéterminée de mesure lorsque le transducteur fonctionne correctement,
- un calculateur électronique comportant :
   - une première et une seconde bornes d'alimentation raccordées, respectivement, au premier et au second potentiels de la source d'alimentation,
   - une borne d'entrée raccordée au câble de mesure,
   - un convertisseur analogique-numérique raccordé à la borne d'entrée pour convertir le signal électrique analogique présent sur la borne d'entrée en un signal numérique, et
   - un microprocesseur programmé pour :
      ∘ commander un équipement électrique en fonction de la valeur du signal numérique si cette valeur numérique correspond à une valeur du signal électrique analogique comprise dans une plage prédéterminée de mesure et, en alternance,
      ∘ signaler l'état coupé du premier câble d'alimentation si la valeur du signal numérique correspond à une première valeur de défaut prédéterminée située en dehors de toute plage prédéterminée de mesure,
- un module de surveillance interposé entre les bornes d'alimentation du capteur et les premier et second câbles d'alimentation, ce module de surveillance étant apte à générer sur le câble de mesure la première valeur de défaut en réponse à la coupure du premier câble d'alimentation.

Pour déterminer si un câble est coupé, il est connu d'utiliser des capteurs inductifs sensibles à la présence du courant qui circule dans ce câble en absence de coupure. C'est ce qui est divulgué, par exemple, par la demande US20030030954. Ces capteurs inductifs sont sensibles aux vibrations. De plus, il est souhaitable de réduire la consommation électrique de tels modules de surveillance et de les simplifier autant que possible pour en réduire le coût.

De l'état de la technique est également connu de US2005/018371A1, JP3150794U, EP3413064A1.

L'invention vise à remédier à au moins un de ces problèmes en proposant une installation électrique conforme à la revendication 1.

L'invention a également pour objet un aéronef comportant cette installation électrique.

Enfin, l'invention a également pour objet un module de surveillance pour la réalisation de l'installation électrique ci-dessus.

L'invention sera mieux comprise à la lecture de la description qui va suivre, donnée uniquement à titre d'exemple non limitatif et faite en se référant aux dessins sur lesquels :
- la figure 1 est une illustration schématique et partielle d'un aéronef équipé d'une installation électrique,
- la figure 2 est un schéma électronique d'une partie des équipements de l'installation électrique de la figure 1,
- la figure 3 est un organigramme d'un procédé de fonctionnement de l'installation électrique de la figure 1,
- la figure 4 est un schéma électronique d'un autre mode de réalisation de l'installation électrique, et
- les figures 5 et 6 sont des schémas électroniques alternatif d'un module de surveillance utilisable dans l'installation électrique et basé sur le schéma de la figure 2.

Dans ces figures, les mêmes références sont utilisées pour désigner les mêmes éléments. Dans la suite de cette description, les caractéristiques et fonctions bien connues de l'homme du métier ne sont pas décrites en détail.

### Chapitre I : Exemples de modes de réalisation

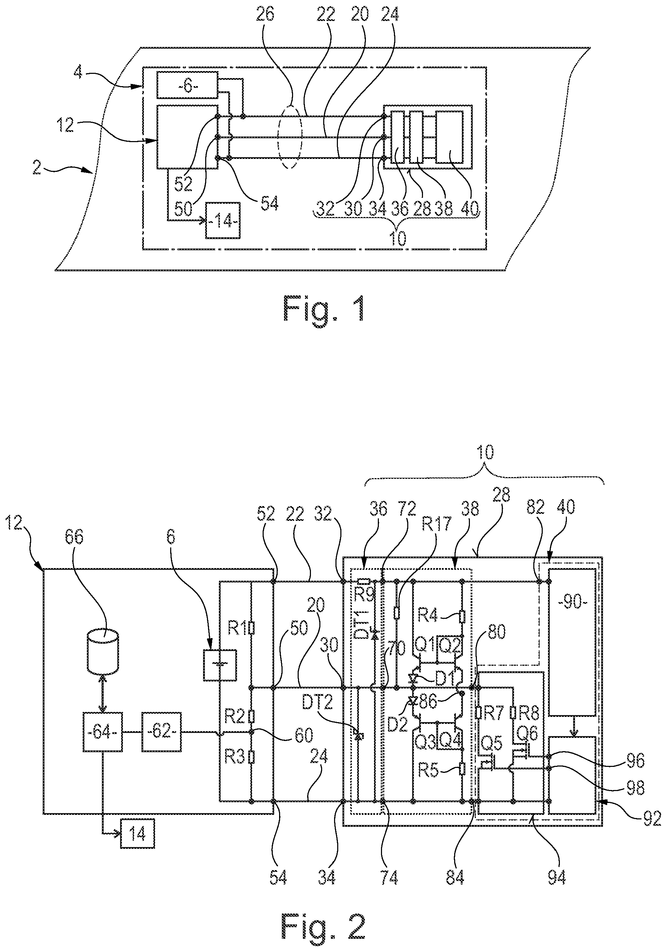

La figure 1 représente un aéronef 2 tel qu'un avion. L'aéronef 2 est équipé d'une installation électrique 4. Seuls les éléments de cette installation électrique nécessaires à la compréhension de l'invention sont représentés et décrits par la suite.

L'installation 4 comporte typiquement de nombreux équipements électriques et de nombreux harnais de câbles raccordant entre eux ces différents équipements électriques. L'installation 4 comporte aussi une source 6 d'alimentation et les harnais de câbles comportent des câbles qui raccordent chaque équipement électrique qui doit être alimenté à la source 6.

Par la suite, sauf précision contraire, le terme « raccorder » signifie raccorder électriquement. Les câbles qui servent à alimenter un équipement électrique sont appelés "câbles d'alimentation". Dans le contexte d'un aéronef qui est généralement électriquement isolé du sol, il faut deux câbles d'alimentation pour alimenter un équipement électrique. L'un de ces câbles d'alimentation a un potentiel supérieur à l'autre de sorte qu'il existe une différence de potentiels entre les bornes d'alimentation de l'équipement électrique. La source 6 est ici une source de tension continue.

Pour simplifier la figure 1, seuls trois équipements électriques de l'installation 4 ont été représentés. Plus précisément, l'installation 4 comporte :
- un équipement 10 de mesure d'une grandeur physique,
- un calculateur électronique 12, et
- un équipement électrique commandable 14.

L'équipement 10 mesure une grandeur physique et la transforme en un signal électrique analogique délivré sur un câble 20 dédié à la transmission de cette mesure. Par la suite, ce câble 20 est appelé « câble de mesure ».

Dans ce mode de réalisation, le signal électrique analogique est un potentiel électrique dont la valeur code la mesure de la grandeur physique.

A titre d'illustration, la grandeur physique est une distance qui sépare une pièce mobile déplaçable en vis-à-vis de l'équipement 10. Plus précisément, l'équipement 10 est un détecteur de proximité qui génère sur le câble 20 un potentiel VON et, en alternance, un potentiel VOFF. Le potentiel VON indique que la pièce mobile est détectée à proximité de l'équipement 10. A l'inverse, le potentiel VOFF indique que la pièce mobile n'est pas détectée et donc qu'elle n'est pas à proximité de l'équipement 10.

L'équipement 10 est également alimenté par deux câbles d'alimentation 22 et 24 raccordés, respectivement, à des potentiels VH et VL de la source 6. Ici, le potentiel VH est supérieur au potentiel VL. Par exemple, VH et VL sont, respectivement, égaux à +28 VDC et 0 VDC.

Les câbles 20, 22 et 24 sont logés, par exemple, à l'intérieur d'un même harnais 26 de câbles. Pour simplifier la figure 1, seuls les câbles 20, 22 et 24 du harnais 26 ont été représentés. Toutefois, dans la réalité, un tel harnais peut comporter plus de dix, vingt ou cent câbles utilisés pour raccorder d'autres équipements électriques à la source 6 et au calculateur 12. Toujours pour simplifier la figure 1, seul le harnais 26 a été représenté. Toutefois, l'installation 4 comporte généralement plus de dix, vingt ou cent harnais différents.

Dans ce mode de réalisation, l'équipement 10 comporte un boîtier 28 à l'intérieur duquel sont logés les différents composants de cet équipement 10. Le boîtier 28 permet notamment de protéger les composants de l'équipement 10 de la poussière, de l'humidité et lui confère une protection contre les perturbations électromagnétiques. L'équipement 10 comporte aussi trois borniers 30, 32 et 34 raccordant l'équipement 10 aux extrémités des câbles, respectivement, 20, 22 et 24.

A l'intérieur du boîtier 10, l'équipement 10 comporte successivement, en partant des borniers 30, 32 et 34 :
- un module 36 de protection électrique,
- un module 38 de surveillance des câbles 22, 24, et
- un capteur 40.

Le module 36 protège les composants électroniques de l'équipement 10 contre les surtensions. Ici, le module 36 protège donc surtout le module 38 et le capteur 40 contre de telles surtensions.

Le module 38 surveille l'état des câbles 22 et 24. Plus précisément, le module 38 est agencé pour détecter une coupure d'un de ces câbles d'alimentation et, en réponse, générer sur le câble 20 un potentiel VDS indiquant la coupure du câble 22 et, en alternance, un potentiel VDR indiquant la coupure du câble 24. Les potentiels VDS et VDR sont différents l'un de l'autre et éloignés des potentiels VON et VOFF délivrés par l'équipement 10 sur le câble 20 en absence de coupure des câbles du harnais 26. Pour cela, le module 38 est conçu pour que les potentiels VDS et VDR soient tous les deux en dehors d'une première plage de mesure [VON - ε ; VON + ε] et d'une seconde plage de mesure [VOFF - ε ; VOFF + ε]. Le nombre ε est un nombre strictement positif supérieur aux fluctuations de la valeur des potentiels VON et VOFF que l'on peut observer lors d'un fonctionnement normal de l'équipement 10. Par exemple, le nombre ε est supérieur à 0,01(VH - VL) ou supérieur à 0,05(VH - VL). Par exemple, le nombre ε est supérieur à 1 volt ou 0,5 volt. Les potentiels VDS et VDR sont également inférieurs ou égaux au potentiel VH et supérieurs ou égaux au potentiel VL.

La coupure d'un câble d'alimentation se traduit par l'interruption de la continuité électrique entre les bornes 32, 34 et les borniers correspondants de la source 6. Dès que l'un des câbles 22, 24 est coupé, l'alimentation de l'équipement 10 est interrompue et celui-ci ne peut plus fonctionner. En particulier, le capteur 40 n'est plus alimenté et ne peut plus générer un potentiel sur le câble 20. Toutefois, même lorsque l'un des câbles 22 ou 24 est coupé, le module 38 reste apte à générer sur le câble 20, le potentiel VDS ou le potentiel VDR selon le câble 22 ou 24 qui a été coupé.

Lorsqu'il est alimenté, le capteur 40 mesure la grandeur physique et génère le potentiel VON et, en alternance, le potentiel VOFF sur le câble 20 selon que la pièce mobile est détectée comme étant à proximité ou non.

Le calculateur 12 est conçu pour traiter les mesures de l'équipement 10 et commander, en fonction de ces mesures, l'équipement 14. A cet effet, il comporte une borne d'entrée 50 raccordée au câble 20 et, par exemple, à une autre extrémité de ce câble 20. Le calculateur 12 est également alimenté par la source 6. A cet effet, il comporte aussi deux bornes d'alimentation 52 et 54 raccordées, respectivement, au potentiel VH et VL de la source 6. Pour cela, ici, les bornes 52 et 54 sont raccordées, respectivement, aux câbles 22 et 24.

L'équipement 14 peut être tout équipement commandable par un calculateur à partir des mesures réalisées par l'équipement 10. Par exemple, l'équipement 14 peut être un actionneur électromécanique ou une interface homme/machine comme un dispositif d'affichage. A titre d'illustration, ici, l'équipement 14 est un dispositif d'affichage apte à afficher les mesures de l'équipement 10 et, en alternance, à indiquer à un être humain la coupure d'un des câbles 22, 24.

La figure 2 représente plus en détail l'architecture d'un premier mode de réalisation du calculateur 12 et de l'équipement 10. Dans ce premier mode de réalisation, le calculateur 12 intègre la source 6 d'alimentation. La source 6 est raccordée entre les bornes 52 et 54 de sorte que les potentiels de ces bornes 52 et 54 sont égaux, respectivement, aux potentiels VH et VL. Ainsi, non seulement le calculateur 12 traite les mesures de l'équipement 10, mais il alimente aussi cet équipement 10. Dans ce cas, les extrémités des câbles 22 et 24 doivent être raccordées, respectivement, aux bornes 52 et 54.

Le calculateur 12 comporte une résistance R1 directement raccordée entre les bornes 50 et 52 et deux résistances R2 et R3 directement raccordées en série entre les bornes 50 et 54. Par « directement raccordé », on désigne le fait de raccorder électriquement un premier composant électrique à un second composant électrique sans passer par l'intermédiaire d'un ou plusieurs composants électroniques actifs et commandables tels que des transistors. Typiquement, un tel raccordement direct est uniquement réalisé à l'aide de pistes conductrices ou de fils conducteurs.

Un point milieu 60 est situé entre les résistances R2 et R3.

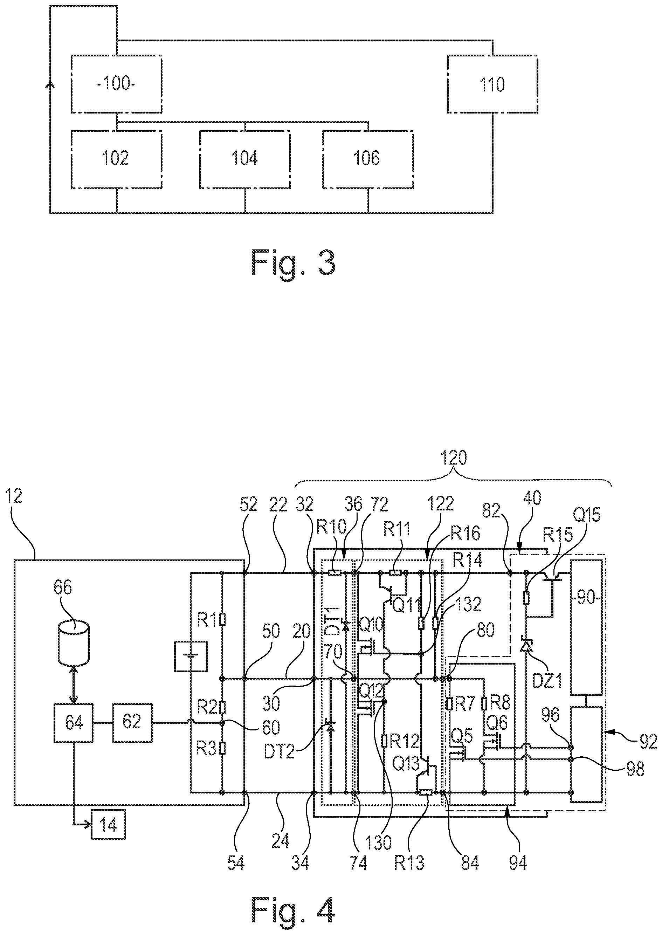

Le calculateur 12 comporte aussi :
- un convertisseur analogique-numérique 62 dont une entrée est raccordée au point milieu 60,
- un microprocesseur 64 programmable, et
- une mémoire 66 comportant des instructions et les données nécessaires pour l'exécution du procédé de la figure 3 lorsqu'elles sont exécutées par le microprocesseur 64.

Le convertisseur 62 transforme le signal électrique analogique présent au niveau du point 60 en une valeur numérique correspondante qui est délivrée au microprocesseur 64. Le signal analogique présent au niveau du point 60 est fonction du potentiel présent au niveau de la borne 50 et donc du potentiel du câble 20. Le potentiel présent sur la borne 50 peut être égal :
- aux potentiels VON ou VOFF en absence de coupure d'un des câbles 22, 24,
- au potentiel VDS en cas de coupure du câble 22, et
- au potentiel VDR en cas de coupure du câble 24.

A cause des résistances R1, R2 et R3, en cas de coupure du câble 20 ou de la coupure simultanée des câbles 22 et 24, le potentiel au niveau de la borne 50 est égal à un potentiel VDO. Les valeurs des résistances R1, R2 et R3 sont ici choisies pour que le potentiel VDO soit différent des potentiels VDS et VDR et également en dehors des plages [VON - ε ; VON + ε] et [VOFF - ε ; VOFF + ε]. Ainsi, le calculateur 12 peut aussi détecter une coupure du câble 20 et/ou la coupure simultanée des câbles 22 et 24. Le potentiel VDO est aussi compris entre les potentiels VH et VL.

Le convertisseur 62 convertit chacun des potentiels en une valeur numérique correspondante et différente les unes des autres. Par la suite, par souci de simplification des notations, on utilise les mêmes notations VON, VOFF, VDS, VDR et VDO pour désigner aussi bien les potentiels précédemment décrits que les cinq valeurs numériques correspondantes obtenues après conversion par le convertisseur 62. Dans ce mode de réalisation, à cause de la résistance R2, le potentiel au niveau du point milieu 60 est plus petit que le potentiel au niveau de la borne 50.

Le microprocesseur 64 est programmé pour exécuter le procédé de la figure 3. A cet effet, il exécute des instructions enregistrées dans la mémoire 66. La mémoire 66 comporte les valeurs de défaut VDS, VDR et VDO et les plages [VON - ε ; VON + ε] et [VOFF - ε ; VOFF + ε]. De plus, la mémoire 66 associe à chacune des valeurs de défaut, la ou les opérations à exécuter si le potentiel relevé au niveau du point 60 correspond à l'une de ces valeurs de défaut. La mémoire 66 associe aussi à chacune des plages [VON - ε ; VON + ε] et [VOFF - ε ; VOFF + ε] la ou les actions à exécuter lorsque la valeur relevée au niveau du point 60 tombe dans l'une de ces plages.

Le module 36 est raccordé, d'un côté, directement aux borniers 30, 32 et 34 et, d'un côté opposé, directement à des points milieux 70, 72 et 74. Le module 36 protège ici le module 38 et le capteur 40 contre les surtensions. A cet effet, il comporte :
- une résistance R9 directement raccordée en série entre le bornier 32 et le point 72,
- une diode Transil DT1 dont la cathode est directement raccordée entre la résistance R9 et le point 72 et dont l'anode est directement raccordée entre le bornier 34 et le point 74,
- une diode Transil DT2 dont la cathode est directement raccordée entre le bornier 30 et le point 70 et dont l'anode est directement raccordée entre le bornier 34 et le point 74.

Les diodes Transil sont également connues sous l'acronyme TVS (« Transient-Voltage-Suppression »).

Le module 38 est raccordé, d'un côté, directement aux points 70, 72 et 74 et, du côté opposé, directement à une borne de sortie 80 et à deux bornes d'alimentation 82 et 84 du capteur 40. La borne 82 est raccordée au câble 22 en passant successivement par le point 72, la résistance R9 et le bornier 32. La borne 84 est raccordée au câble 24 en passant successivement par le point 74 et le bornier 34. La borne 80 est raccordée au câble 20 en passant successivement par le point 70 et le bornier 30.

Le module 38 comporte deux transistors Q1 et Q3. Chaque transistor comporte deux électrodes de puissance et une électrode de commande. Chaque transistor est commutable de façon réversible, en réponse à un signal de commande reçu sur son électrode de commande, entre :
- un état fermé où ses deux électrodes de puissance sont électriquement raccordées l'une à l'autre, et
- un état ouvert où ses deux électrodes de puissance sont électriquement isolées l'une de l'autre.

Ainsi, dans l'état fermé, le courant peut traverser le transistor alors que dans l'état ouvert, ce courant ne traverse pas le transistor. Pour cela, dans l'état ouvert, le transistor offre une résistance au passage du courant de l'une de ces électrodes de puissance vers l'autre plusieurs centaines de fois plus élevée que dans l'état fermé.

Dans le cas présent, les transistors Q1 et Q3 sont des transistors bipolaires. Ainsi, les électrodes de puissance de ces transistors sont habituellement appelées, respectivement, "collecteur" et "émetteur" et l'électrode de commande est appelée "base". Plus précisément, le transistor Q1 est un transistor NPN et le transistor Q3 est un transistor PNP.

L'émetteur du transistor Q1 est raccordé au point 70 par l'intermédiaire d'une diode D1. La cathode de la diode D1 est directement raccordée au point 70. Le collecteur du transistor Q1 est directement raccordé au point 72. L'émetteur du transistor Q3 est raccordé au point 70 par l'intermédiaire d'une diode D2. L'anode de la diode D2 est directement raccordée au point 70. Le collecteur du transistor Q3 est directement raccordé au point 74.

Le module 38 comporte également un pont directement raccordé entre les bornes 82 et 84. Ce pont comporte successivement, raccordé en série, en partant de la borne 82 et en allant vers la borne 84 :
- une résistance R4,
- un transistor Q2,
- un point milieu 86,
- un transistor Q4, et
- une résistance R5.

Ce pont est électriquement isolé de la borne de sortie 80 et du bornier 30.

De préférence, les résistances R4 et R5 sont choisis pour que la relation suivante soit vérifiée : (V70-VD2)/(VH-VL) < V86/(VH-VL) < (V70+VD1)/(VH-VL), où :
- V70 et V86 sont les potentiels au niveau, respectivement, des points 70 et 86, et
- VD1 et VD2 sont les chutes de tensions entre la cathode et l'anode, respectivement, des diodes D1 et D2.

Pour que la relation ci-dessus soit vérifiée, en pratique, la somme des valeurs des résistances R4 et R5 est proche de la somme des valeurs des résistances R2 et R3. De plus, de préférence, les valeurs des résistances R4 et R5 sont choisies pour que le rapport R5/(R4+R5) soit proche de un. A titre d'exemple, lorsque la somme des valeurs des résistances R2 et R3 est égale à 60000 Ohms et lorsque la valeur de la résistance R1 est égale à 3500 Ohms, les valeurs des résistances R4 et R5 sont égales, respectivement, à 2000 Ohms et 60000 Ohms.

Les transistors Q2 et Q4 sont identiques, respectivement, aux transistors Q1 et Q3. Le collecteur du transistor Q2 est directement raccordé à la résistance R4 et son émetteur est directement raccordé au point 86. Le collecteur du transistor Q4 est directement raccordé à la résistance R5 et son émetteur est directement raccordé au point 86. La base du transistor Q1 est directement raccordée, d'une part, à la base du transistor Q2 et, d'autre part, entre le collecteur du transistor Q2 et la résistance R4. La base du transistor Q3 est directement raccordée, d'une part, à la base du transistor Q4 et, d'autre part, entre le collecteur du transistor Q4 et la résistance R5.

Le module 38 comporte donc au plus quatre transistors.

Le module 38 comporte aussi une résistance R17 directement raccordée entre les bornes 70 et 72. Cette résistance R17 est une résistance de tirage pour éviter de laisser le potentiel du câble 20 flottant en cas de défaut, notamment, dans une interface 94 du capteur 40. L'interface 94 est décrite ci-dessous.

Le capteur 40 est alimenté par la tension présente entre les bornes 82 et 84. Le signal électrique analogique correspondant à la grandeur physique mesurée est délivré sur la borne 80. Le capteur 40 comporte notamment :
- un transducteur 90,
- un comparateur 92, et
- l'interface 94.

Le transducteur 90 transforme la grandeur physique mesurée en un signal électrique mesuré transmis au comparateur 92. Le comparateur 92 compare la valeur du signal électrique mesuré à un seuil prédéterminé. Si la valeur du signal électrique mesurée est au-dessus de ce seuil, c'est-à-dire que la proximité de la pièce mobile est détectée, le comparateur 92 génère un signal de commande seulement sur un port 96 de sortie. A l'inverse, si la valeur du signal électrique mesurée est au-dessous de ce seuil, c'est-à-dire que la proximité de la pièce mobile n'est pas détectée, le comparateur 92 génère un signal de commande seulement sur un port 98.

L'interface 94 comporte une première et une seconde branches raccordées en parallèle entre les bornes 80 et 84. La première branche comporte successivement raccordée en série, en partant de la borne 80 et en allant vers la borne 84, une résistance R7 et un transistor Q5. Le transistor Q5 est un transistor à effet de champ à grille isolée à enrichissement de type N. Les transistors à effet de champ à grille isolée sont plus connus sous l'acronyme MOSFET (« Metal-Oxide Semiconductor Field-Effect Transistor »). Dans le cas des transistors MOSFET, les électrodes de puissance correspondent à la source et au drain et l'électrode de commande correspond à la grille.

Le drain et la source du transistor Q5 sont directement raccordés, respectivement, à la résistance R7 et à la borne 84. La grille du transistor Q5 est directement raccordée au port 98.

La seconde branche est identique à la première branche sauf que la résistance R7 est remplacée par une résistance R8 et que la grille du transistor Q6 est directement raccordée au port 96. Le transistor Q6 est identique au transistor Q5.

La résistance R8 est différente de la résistance R7. Les valeurs des résistances R7 et R8 déterminent respectivement, les valeurs des potentiels VOFF et VON. Par exemple, les valeurs des résistances R7 et R8 sont égales, respectivement, à 6990 Ohms et 11150 Ohms.

Avec les valeurs numériques précédemment données pour les résistances et dans le cas où les potentiels VH et VL sont égaux, respectivement, à +28 Vdc et 0 Vdc, les potentiels VON, VOFF, VDS, VDR et VDO sont, par exemple, égaux à 20,37 Vdc, 18,33 Vdc, 3,03 Vdc, 26,74 Vdc et 26,02 Vdc.

Le fonctionnement de l'installation électrique 4 va maintenant être décrit en référence au procédé de la figure 3. Par la suite, on note V50, V70 et V86 les potentiels électriques au niveau, respectivement, de la borne 50 et des points 70 et 86.

Lors d'une phase 100 de fonctionnement normal, aucun des câbles 20, 22 et 24 n'est coupé. Dans ces conditions, les potentiels V50 et V86 sont proches. Dans ces conditions, les transistors Q1 et Q3 sont dans leur état ouvert. Le potentiel du câble 20 est alors fixé par l'interface 94. Plus précisément, si la pièce mobile est détectée à proximité du transducteur 90, le transistor Q6 est dans son état fermé et le transistor Q5 est dans son état ouvert. Le potentiel du câble 20 est alors égal au potentiel VON. A l'inverse, si la pièce mobile n'est pas détectée comme étant à proximité du transducteur 90, le transistor Q6 est dans son état ouvert et le transistor Q5 est dans son état fermé. Le potentiel du câble 20 est alors imposé par la résistance R7 et correspond au potentiel VOFF.

Lors d'une première phase 102 de défaillance, seul le câble 22 est coupé. Le capteur 40 n'est alors plus alimenté et les transistors Q5 et Q6 sont donc simultanément dans leur état ouvert. Le potentiel V86 devient alors inférieur au potentiel V50. Le transistor Q3 commute donc dans son état fermé alors que le transistor Q1 reste dans son état ouvert. Dans ces conditions, le potentiel du câble 20 est égal au potentiel VDS.

Lors d'une deuxième phase 104 de défaillance, seul le câble 24 est coupé. De façon similaire à ce qui a été décrit lors de la phase 102, le capteur 40 n'est plus alimenté et les transistors Q5 et Q6 sont simultanément dans leur état ouvert. Le potentiel V86 devient alors supérieur au potentiel V50 ce qui provoque la commutation du transistor Q1 vers son état fermé alors que le transistor Q3 reste dans son état ouvert. Dans ces conditions, le potentiel du câble 20 est égal au potentiel VDR.

Lors d'une troisième phase 106 de défaillance, seul le câble 20 est coupé ou les câbles 22 et 24 sont coupés simultanément. Dans ce cas, le potentiel V50 au niveau de la borne 50 devient égal au potentiel VDO.

En parallèle de ces différentes phases, lors d'une phase 110, le calculateur 12 convertit en permanence le potentiel au niveau du point 60 en une valeur numérique traitée par le microprocesseur 64. Le microprocesseur 64 commande alors un ou plusieurs équipements électriques en fonction de cette valeur numérique. Par exemple, si le potentiel au niveau de la borne 50 et l'un des potentiels VDS, VDR, VDO, il commande l'équipement 14 pour afficher un message d'erreur signalant qu'un câble est coupé. Typiquement, ce message d'erreur identifie en plus le câble coupé parmi les câbles 20, 22 et 24.

Si le potentiel sur la borne 50 est égal au potentiel VON ou VOFF, il commande l'équipement 14 pour afficher un message qui indique la détection de la pièce mobile à proximité du capteur 40 et, en alternance, l'absence de cette détection.

La figure 4 représente un équipement 120 susceptible d'être utilisé à la place de l'équipement 10. L'équipement 120 est ici identique à l'équipement 10 sauf que le module 38 de surveillance est remplacé par un module 122 de surveillance.

Le module 122 remplit les mêmes fonctions que le module 38, c'est-à-dire qu'il génère sur le câble 20 le potentiel VDS lorsque le câble 22 est coupé et, en alternance, le potentiel VDR lorsque le câble 24 est coupé. Toutefois, dans ce mode de réalisation, au lieu d'exploiter la disparition du potentiel sur le câble coupé pour commander les transistors, c'est la disparition du courant dans le câble coupé qui est utilisée pour commander ces transistors.

Plus précisément, comme dans le module 38, le module 122 comporte deux transistors Q10 et Q12 raccordés aux câbles 20, 22 et 24 comme décrits précédemment pour les transistors Q1 et Q3. Ici, les transistors Q10 et Q12 sont, respectivement, un transistor MOSFET de type P à enrichissement et un transistor MOSFET de type N à enrichissement. Les sources des transistors Q10 et Q12 sont directement raccordées au point 70.

Le module 122 comporte aussi une résistance R11 raccordée en série entre le point 72 et la borne 82 et une résistance R13 raccordée en série entre le point 74 et la borne 84. Le module 122 comporte deux transistors Q11 et Q13 raccordés aux bornes, respectivement, des résistances R11 et R13. Ici, les transistors Q11 et Q13 sont des transistors bipolaires, respectivement, PNP et NPN. L'émetteur du transistor Q11 est directement raccordé au point 72. La base du transistor Q11 est directement raccordée entre la résistance R11 et la borne 82. Le collecteur du transistor Q11 est directement raccordé à la grille du transistor Q12. La grille du transistor Q12 est aussi raccordée entre le point 74 et la résistance R13 en passant par l'intermédiaire d'une résistance R12.

L'émetteur du transistor Q13 est directement raccordé entre le point 74 et la résistance R13. La base du transistor Q13 est directement raccordée entre la résistance R13 et la borne 84. Le collecteur du transistor Q13 est directement raccordé à la grille du transistor Q10. La grille du transistor Q10 est raccordée entre la résistance R11 et la borne 82 en passant par l'intermédiaire d'une résistance R16 .

Une résistance R14 est également directement raccordée entre les bornes 80 et 82. La résistance R14 remplit ici la même fonction que la résistance R17 du module 38.

Sur la figure 4, le schéma électronique du capteur 40 a été précisé pour faire ressortir certains de ses composants qui permettent de mieux comprendre le fonctionnement de l'équipement 120. Le capteur 40 comporte, raccordé en série entre les bornes 82 et 84, successivement une résistance R15 et une diode Zener DZ1. La cathode de la diode DZ1 est directement raccordée à la résistance R15. Le capteur 40 comporte également, raccordé en série avec le câble 22, un transistor Q15 dont le collecteur est directement raccordé à la borne 82 et l'émetteur est raccordé au transducteur 90. La base du transistor Q15 est directement raccordée entre la résistance R15 et la cathode de la diode DZ1.

Le fonctionnement de l'équipement 120 est identique à celui de l'équipement 10 sauf qu'ici la coupure du câble 22 ou du câble 24 est détectée à partir du courant qui circule dans ces câbles. Pour ces explications du fonctionnement du module 122, on note V130 et V132 les potentiels électriques au niveau, respectivement, d'un point 130 directement raccordé à la grille du transistor Q12 et d'un point 132 directement raccordé à la grille du transistor Q10.

En absence de coupure des câbles 22 et 24, les résistances R11 et R13 sont traversées par des courants d'intensité non nulle ce qui provoque une chute de tension aux bornes de ces résistances. Cette chute de tension maintient les transistors Q11 et Q13 dans leur état fermé. L'écart V50 - V130 entre les potentiels V50 et V130 est alors inférieur à un seuil Vg12 au-delà duquel le transistor Q12 commute dans son état fermé. De même, l'écart V132 - V50 entre les potentiels V132 et V50 est aussi inférieur à un seuil Vg10 au-delà duquel le transistor Q10 commute dans son état fermé. Ainsi, en absence de coupure des câbles 22 et 24, les transistors Q10 et Q12 sont dans leur état ouvert.

Lorsque seul le câble 22 est coupé, l'intensité du courant dans ce câble 22 devient nulle. La chute de tension aux bornes de la résistance R11 est alors également nulle ce qui provoque la commutation du transistor Q11 vers son état ouvert. Le potentiel V130 diminue alors et l'écart V50 - V130 devient supérieur au seuil Vg12. Le transistor Q12 commute donc dans son état fermé. Dans le même temps, le courant qui traverse la résistance R13 ne s'annule pas. En effet, même lorsque le câble 22 est coupé, il existe une différence de potentiels entre les bornes 80 et 84. Cette différence de potentiels est causée par les résistances R1, R2 et R3 du calculateur 12. Il existe donc un courant non nul qui traverse la résistance R14, la résistance R15, la diode DZ1 et la résistance R13. Ce courant non nul est suffisant pour maintenir le transistor Q13 dans son état fermé et donc le transistor Q10 dans son état ouvert. Dans ces conditions, le module 122 génère le potentiel VDS sur le câble 20. Ainsi, le calculateur 12 peut détecter et signaler la coupure du câble 22.

Lorsque seul le câble 24 est coupé, l'intensité du courant dans ce câble 24 est nulle. La chute de tension aux bornes de la résistance R13 est alors aussi nulle ce qui provoque la commutation du transistor Q13 vers son état ouvert. Le potentiel V132 augmente alors et l'écart V132 - V50 devient supérieur au seuil Vg10. Le transistor Q10 commute donc dans son état fermé. Dans le même temps, le courant qui traverse la résistance R11 ne s'annule pas ce qui maintient le transistor Q12 dans son état ouvert. Dans ce cas, le courant non nul qui traverse la résistance R11 provient du fait que, même si le câble 24 est coupé, il existe une différence de potentiels entre les bornes 80 et 82. Il existe donc un courant non nul qui traverse successivement la résistance R14 et la résistance R11. Ce courant est suffisant pour maintenir le transistor Q11 dans son état fermé et donc le transistor Q12 dans son état ouvert. Ainsi, en cas de coupure du câble 24, le module 122 génère le potentiel VDR sur le câble 20. Dès lors, le calculateur peut détecter et signaler la coupure du câble 24.

Le reste du fonctionnement du module 122 est identique à celui qui a été décrit en référence au procédé de la figure 3.

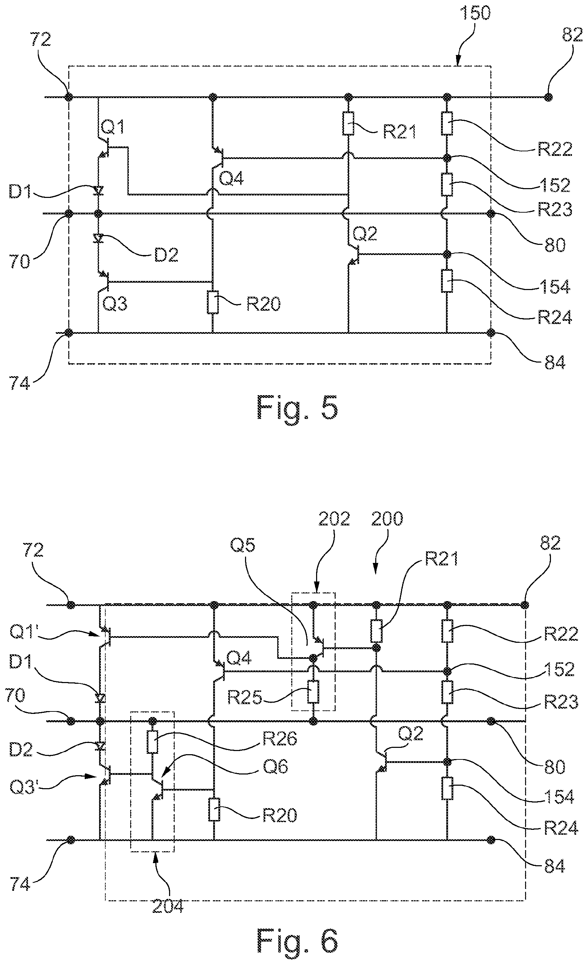

La figure 5 représente un module 150 de surveillance apte à détecter une coupure du câble 22 et, en alternance, du câble 24 à partir de la chute de tension que cela provoque dans le câble coupé. Le module 150 est susceptible d'être utilisé à la place du module 38 de la figure 2. Le module 150 est identique au module 38 sauf que les électrodes de commande des transistors Q1 et Q3 ne sont pas raccordées de la même façon, respectivement, aux câbles 24 et 22. Dans ce mode de réalisation, l'émetteur du transistor Q2 est directement raccordé à la borne 84. Le collecteur du transistor Q2 est raccordé à la borne 82 par l'intermédiaire d'une résistance R21. La base du transistor Q1 est directement raccordée entre cette résistance R21 et le transistor Q2. L'émetteur du transistor Q4 est directement raccordé à la borne 82. Le collecteur du transistor Q4 est raccordé à la borne 84 par l'intermédiaire d'une résistance R20. La base du transistor Q3 est directement raccordée entre cette résistance R20 et le transistor Q4.

Le module 150 comporte également un pont de trois résistances R22, R23 et R24 raccordées en série entre les bornes 82 et 84. Plus précisément, la résistance R22 est directement raccordée entre la borne 82 et un point milieu 152. La résistance R23 est directement raccordée entre le point 152 et un point milieu 154. La résistance R24 est directement raccordée entre le point 154 et la borne 84. Les bases des transistors Q2 et Q4 sont directement raccordées, respectivement, aux points milieux 154 et 152. Les valeurs des résistances R23, R24 et R25 sont choisies pour que :
- en absence de coupure des câbles 22 et 24, les transistors Q2 et Q4 sont dans leurs états fermés,
- en réponse à une coupure du câble 22, seul le transistor Q4 bascule vers son état ouvert, et
- en réponse à une coupure du câble 24, seul le transistor Q2 bascule vers son état fermé ouvert.

Le fonctionnement du module 150 est le suivant. Lorsque le câble 22 est coupé, le potentiel aux niveaux des points 152 et 154 chutent ce qui provoque l'ouverture des transistors Q4 et Q2. L'ouverture du transistor Q4 provoque à son tour la fermeture du transistor Q3 puisque le potentiel au niveau du point 70 est supérieur au potentiel au niveau du point 74. Dans le cas d'une coupure du câble 24, plus aucun courant ne peut circuler dans le pont de résistances R22-R23-R24.Les transistors Q4 et Q2 sont bloqués, c'est-à-dire dans leurs états ouverts. Dans ces conditions, seul le transistor Q1 est passant puisque le potentiel au niveau du point 72 est supérieur au potentiel au niveau du point 70.

La figure 6 représente un module 200 de surveillance apte à détecter une coupure du câble 22 et, en alternance, du câble 24 à partir de la chute de tension que cela provoque dans le câble coupé. Le module 200 est susceptible d'être utilisé à la place du module 38 de la figure 2. Le module 200 est identique au module 150 sauf que :
- les transistors Q1 et Q3 sont chacun remplacés par des transistors bipolaires, respectivement, Q1' et Q3', et
- des étages inverseurs 202 et 204 sont introduits entre les bases des transistors Q1' et Q3' et, respectivement, les transistors Q2 et Q4.

Les transistors Q1' et Q3' sont identiques, respectivement, aux transistors Q1 et Q3 sauf que leurs polarités sont inversées. Ainsi, dans le module 200, ce sont les collecteurs des transistors Q1' et Q3' qui sont directement raccordés, respectivement, à l'anode de la diode D1 et à la cathode de la diode D2.

L'étage inverseur 202 comporte, raccordé en série entre les bornes 82 et 80, un transistor bipolaire Q5 et une résistance R25. L'émetteur du transistor Q5 est directement raccordé à la borne 82 et son collecteur est raccordé à la borne 80 en passant par l'intermédiaire de la résistance R25. La base du transistor Q5 est directement raccordée entre la résistance R21 et le collecteur du transistor Q2.

L'étage inverseur 204 comporte, raccordé en série entre les bornes 80 et 84, un transistor bipolaire Q6 et une résistance R26. L'émetteur du transistor Q6 est directement raccordé à la borne 84 et son collecteur est raccordé à la borne 80 en passant par l'intermédiaire de la résistance R26. La base du transistor Q6 est directement raccordée entre la résistance R20 et le collecteur du transistor Q4.

Le fonctionnement du module 200 est similaire à celui du module 150 sauf que les signaux de commande des transistors Q1' et Q3' sont inversés. Plus précisément, le coupure du câble 22 provoque, comme expliqué précédemment pour le module 150, l'ouverture du transistor Q4. L'ouverture du transistor Q4 provoque l'ouverture du transistor Q6 qui provoque à son tour la fermeture du transistor Q3'. De façon similaire, la coupure du câble 24 provoque l'ouverture des transistors Q2 et Q5 et la fermeture du transistor Q1'. Ce mode de réalisation est intéressant en ce qu'il permet de saturer plus fortement les transistors Q1' et Q3' en réponse à une coupure, respectivement, des câbles 24 et 22.

### Chapitre II : Variantes :

### Variantes du module de surveillance :

Dans une variante simplifiée, seul l'état d'un des deux câbles d'alimentation 22 ou 24 est surveillé. Dans ce cas, l'architecture du module de surveillance peut être simplifiée.

Par exemple, seul l'état du câble 22 est surveillé. Le module 38 est alors simplifié en supprimant le transistor Q1 et en le remplaçant par un circuit électrique systématiquement ouvert. Le transistor Q2 est remplacé par un circuit électrique systématiquement fermé comme une piste conductrice. Le module 122 est alors simplifié en supprimant les transistors Q10 et Q13 et en les remplaçant par des circuits électriques systématiquement ouverts. La résistance R13 est aussi omise et remplacée par une liaison filaire. Toujours dans ce cas, le module 150 peut être simplifié en remplaçant le transistor Q1 par un circuit électrique systématiquement ouvert et en supprimant la résistance R21, le transistor Q2 et la résistance R24. De façon similaire, les composants du module 200 seulement utilisés pour la surveillance de l'état du câble 24 peuvent être omis. Lorsque seule l'état du câble 22 est surveillé, le calculateur 12 n'est pas programmé pour surveiller et signaler l'état coupé du câble 24.

Da façon similaire, l'architecture des modules 38, 122, 150 et 200 peut être simplifiée si seul l'état du câble 24 est surveillé.

Le module de surveillance peut être situé dans un boîtier indépendant du boîtier 28 contenant le capteur 40. Dans ce cas, de préférence, le module de surveillance est raccordé au câble 22, 24 à un endroit aussi proche que possible du boîtier 28 contenant le capteur 40.

D'autres modes de réalisation du module 38 de surveillance sont possibles. Par exemple, les transistors Q2 et Q4 sont remplacés, respectivement, par des première et seconde diodes. La cathode de la première diode et l'anode de la seconde diode sont alors directement raccordées au point 86. Les transistors Q2 et Q4 peuvent aussi être remplacés par une simple liaison filaire. Dans ce dernier cas, les valeurs des résistances R4 et R5 doivent être adaptées. En particulier, pour le choix des valeurs des résistances R4 et R5, il faut alors en plus tenir compte des tensions des jonctions base-émetteur des transistors Q1 et Q3.

D'autres modes de réalisation du module 150 ou 200 sont également possibles. Par exemple, le pont comportant les résistances R21, R22 et R24 est remplacé par un premier et un second ponts parallèles comportant chacun deux résistances. Les bases des transistors Q4 et Q2 sont alors raccordées entre les deux résistances, respectivement, du premier et du second ponts.

Dans une variante simplifiée, les diodes D1 et D2 sont omises. Dans ce cas, après une coupure d'un des câbles 22, 24, les potentiels VDS et VDR apparaissent puis disparaissent après un certain temps. Dans ce cas, les potentiels VDS et VDR sont dit "transitoires". Le calculateur 12 est adapté pour détecter un défaut à partir de tels potentiels transitoires.

Les transistors bipolaires peuvent être remplacés par d'autres types de transistors comme par exemple des transistors MOSFET. De façon réciproque, les transistors MOSFET peuvent être remplacés par d'autres types de transistors comme par exemple des transistors bipolaires. Lorsque les transistors MOSFET du module 122 sont remplacés par des transistors bipolaires, de préférence, les les diodes D1 et D2 sont ajoutées dans le modules 122 de façon similaire à ce qui a été décrit pour le module 38.

En variante, le transistor Q11 est remplacé par un transistor bipolaire NPN dont la base est directement raccordée entre les résistances R10 et R11 et dont le collecteur est raccordé entre la résistance R11 et la borne 82. Une modification similaire peut être apportée au transistor Q13.

Les modules 38, 122, 150 et 200 peuvent être adaptés pour coder les défauts des câbles 22, 24 non pas avec des potentiels spécifiques VDS et VDR mais par des intensités spécifiques IDS et IDR d'un courant généré sur le câble 20. Dans ce cas, le convertisseur 12 est adapté pour également relever l'intensité du courant sur le câble 20. L'intensité de ces courants codant les défauts est par exemple réglée en raccordant des résistances en série avec les transistors Q1, Q3, Q10 et Q12.

Des étages inverseurs, tels que les étages 202 et 204, peuvent aussi être mis en oeuvre dans le module 122 de façon similaire à ce qui a été décrit en référence à la figure 6.

Dans tous les modes de réalisation, des résistances supplémentaires peuvent être ajoutées, notamment en série avec les transistors, par exemple, pour limiter ou annuler les conséquences d'éventuelles variations de température sur le fonctionnement du module de surveillance.

### Variantes du capteur :

Le nombre de plages prédéterminé de mesures possibles pour le capteur peut être supérieur à deux. C'est par exemple le cas si le capteur 40 détecte trois états différents de la grandeur physique mesurée et fait correspondre à chacun de ces trois états, trois potentiels différents V1, V2 et V3.

Dans un autre mode de réalisation, la grandeur physique mesurée et délivrée par le capteur varie de façon continue sur une plage de potentiels [LMIN ; LMAX] ; où LMIN et LMAX sont des limites différentes espacées l'une de l'autre par au moins 1 volt ou 0,5 volt. Dans ce cas, la plage [LMIN ; LMAX] est comprise entre les potentiels VDR et VDO ou entre les potentiels VDO et VDS de manière à ce que cette plage ne soit pas à cheval sur l'un des potentiels VDS, VDO et VDR. Dans le cas d'une mesure continue de la grandeur physique, généralement, il n'existe qu'une seule plage de mesures.

Ce qui a été précédemment décrit s'applique à tout type de capteur alimenté par l'intermédiaire de deux câbles d'alimentation et qui transmettent leurs mesures par l'intermédiaire d'un câble de mesure indépendant des deux câbles d'alimentation. En particulier, la nature de la grandeur physique n'a pas d'importance. Par exemple, la grandeur physique peut être un champ magnétique, l'intensité d'un courant, une tension, une température, l'intensité d'un rayonnement lumineux ou autre. L'information mesurée sur la grandeur physique peut être seulement une information binaire comme dans le cas du capteur 40 ou une information qui varie continûment sur une plage de mesures en fonction des variations de la grandeur physique mesurée.

### Autres variantes :

En variante, la source d'alimentation est indépendante du calculateur 12 et située en dehors du calculateur 12.

Dans une autre variante simplifiée, le calculateur n'est pas programmé pour surveiller et signaler l'état coupé du câble 20.

Le calculateur 12 n'est pas nécessairement réalisé à l'aide d'un microprocesseur programmable. Par exemple, il peut aussi être réalisé sous la forme d'un circuit électronique en dur, c'est-à-dire non reprogrammable, comme par exemple, à partir d'amplificateurs opérationnels agencés pour comparer le potentiel au niveau de la borne 50 au potentiel VON, VOFF, VDS, VDR et VDO.

D'autres modes de réalisation du module 36 de protection sont possibles. Par exemple, en variante, le module 36 est agencé pour protéger, en plus ou à la place, le module 38 et le capteur 40 contre des surintensités. Il est aussi possible de réaliser ces mêmes fonctions avec d'autres composants électroniques que des diodes Transil.

Ce qui a été décrit ici peut être implémenté dans d'autres véhicules qu'un aéronef. Par exemple, l'installation électrique peut être implémentée dans un véhicule automobile, un véhicule ferroviaire ou même une installation semi-mobile ou fixe. L'installation électrique peut être aussi mise en oeuvre dans d'autres aéronefs qu'un avion comme par exemple, un hélicoptère.

Il n'est pas nécessaire que les différents câbles surveillés par le module de surveillance soient tous logés dans le même harnais. En particulier, dans un mode de réalisation particulier, les différents câbles surveillés sont logés dans différents harnais.

Pour que ce qui a été décrit ici fonctionne, il n'est pas nécessaire que les bornes 52 et 54 soient directement raccordées aux câbles 22 et 24. Il suffit simplement que les bornes 52 et 54 soient raccordées, respectivement, aux potentiels VH et VL. Pour cela, des câbles différents des câbles 22 et 24 peuvent être utilisés.

### Chapitre III : Avantages des modes de réalisation décrits :

### Avantages communs aux différents modes de réalisation :

Le fait d'utiliser un transistor dont l'électrode de commande est raccordée au câble à surveiller permet de faire commuter simplement l'état de ce transistor en réponse à une coupure de ce câble sans qu'il soit pour cela nécessaire d'utiliser un capteur plus complexe de courant ou de tension tel qu'un capteur de champ magnétique. De plus, puisque le module de surveillance n'utilise que des transistors et des résistances et n'utilise donc pas de capteur plus complexe, il est plus résistant aux vibrations.

Le fait que les électrodes de puissance de ce transistor soient raccordées entre le câble de mesure et l'autre câble d'alimentation permet simplement de coder l'information sur l'état du câble à surveiller, et cela quel que soit l'état coupé ou non du câble d'alimentation surveillé. De plus, cela permet d'utiliser un signal électrique pour coder la présence d'un défaut sur le câble 20 qui laisse de larges plages possibles pour coder les mesures du capteur sans que ces valeurs ne se chevauchent avec l'une des valeurs utilisées pour coder un défaut.

Le fait que le module de surveillance soit interposé entre les bornes du capteur et les bornes du calculateur permet de détecter une coupure d'un câble d'alimentation indépendamment de l'état de fonctionnement du capteur.

Les modules de surveillance décrits ici comportent très peu de composants électroniques. Ils sont donc à la fois simples à réaliser, consomment très peu d'énergie et sont peu coûteux.

L'utilisation à la fois des transistors Q1 et Q3 ou Q10 et Q12 dans le module de surveillance permet de détecter aussi bien une coupure du câble 22 qu'une coupure du câble 24 tout en restant capable de discriminer ces deux défauts.

Fixer les potentiels VDS et VDR pour qu'ils soient différents du potentiel VDO permet en plus de détecter la coupure du câble de mesure et/ou la coupure simultanée des câbles 22 et 24.

L'utilisation d'un étage inverseur, tel que l'étage 202 ou 204 du module 200, permet de saturer d'avantage les transistors utilisés pour générer les potentiels VDS et VDR.

### Avantages spécifiques aux modules 38, 150, 200 :

Lorsque la fermeture du transistor Q1 ou Q3 est déclenchée par la disparition du potentiel sur le câble d'alimentation surveillé, cela permet de signaler la coupure d'un de ces câbles d'alimentation indépendamment du courant qui circule sur ce câble d'alimentation. Ainsi, ce mode de réalisation est robuste vis-à-vis des perturbations du courant qui pourrait être causées par une défaillance du capteur 40.

Le module 150 est avantageux par rapport au module 38 en ce qu'il laisse une plus grande latitude sur le choix des valeurs des résistances R7 et R8 et donc sur le choix des valeurs des potentiels VON et VOFF. En effet, dans le module 38, lorsque le transistor Q5 est dans l'état fermé, la résistance R7 est raccordée en parallèle des résistance R2 et R3 ce qui modifie la valeur de la résistance entre les bornes 50 et 54 du calculateur 12. Or, la valeur de la résistance R5 doit rester proche de la valeur de la résistance entre les bornes 50 et 54. Cette contrainte de proximité limite les choix possibles pour la valeur de la résistance R7. De façon similaire, les choix possibles pour la valeur de la résistance R8 sont également contraints. Le module 150 allège ces contraintes sur le choix des valeurs des résistances R7 et R8. En effet, les valeurs des résistances R22, R23 et R24 ne sont pas imposées par les valeurs des résistances R1, R2 et R3. En particulier, avec le module 150 l'écart entre les potentiels VDO et VDR peut être augmenté.

Dans le module 38, le fait de raccorder l'électrode de commande des transistors Q1 et Q3 au point 86 permet de commuter ces transistors en fonction des potentiels présents sur les câbles 22 et 24 et indépendamment du courant qui peut circuler sur ces mêmes câbles.

Dans le module 38, l'utilisation des transistors Q2 et Q4 permet de compenser la chute de tension entre l'électrode de commande et l'électrode de puissance des transistors Q1 et Q3. Cela rend le fonctionnement du module 38 plus fiable.

L'utilisation des diodes D1 et D2 évite que les potentiels VDS et VDR soient transitoires. Lorsqu'une telle diode D1 ou D2 est utilisée en combinaison avec un transistor MOSFET, elle empêche un retour de courant de la source vers le drain du transistor MOSFET, à cause de la diode intrinsèque d'un MOSFET, en réponse à une coupure du câble 22 ou 24.

### Avantages du module 122 :

Lorsque la fermeture du transistor Q10 ou Q12 est déclenchée par une variation de l'intensité du courant qui circule dans le câble d'alimentation surveillé, cela permet de signaler la coupure de ce câble d'alimentation surveillé indépendamment du potentiel présent sur ce câble. Ainsi ce mode de réalisation est robuste vis-à-vis des perturbations du potentiel du câble d'alimentation causées, par exemple, par une défaillance du capteur.

L'utilisation de seulement un transistor Q11 ou Q13 et de seulement une résistance R11 et R13 pour générer le signal de commande du transistor Q10 ou Q12 limite le nombre de composants et simplifie le module 122 de surveillance.

## Revendications

1. Installation électrique comportant :
- un premier et un second câbles (22, 24) d'alimentation raccordés, respectivement, à un premier et un second potentiels différents d'une source d'alimentation,
- un câble (20) de mesure, les premier et second câbles d'alimentation et le câble de mesure étant logés à l'intérieur d'un ou plusieurs harnais (26) de câbles,
- un capteur (40) apte à mesurer une grandeur physique, ce capteur comportant :
• une première et une seconde bornes (82, 84) d'alimentation raccordées, respectivement, au premier et au second câbles d'alimentation,
• une borne (80) de sortie raccordée au câble de mesure, et
• un transducteur (90) alimenté par l'intermédiaire des première et seconde bornes d'alimentation du capteur, ce transducteur étant apte à transformer la grandeur physique mesurée en un signal électrique correspondant, et
• le capteur est apte à délivrer, sur sa borne (80) de sortie, un signal électrique analogique codant la mesure de la grandeur physique par une valeur correspondante d'un potentiel ou de l'intensité d'un courant, la valeur du signal électrique délivré sur le câble de mesure étant systématiquement comprise dans une plage prédéterminée de mesure lorsque le transducteur fonctionne correctement,
- un calculateur électronique (12) comportant :
• une première et une seconde bornes (52, 54) d'alimentation raccordées, respectivement, au premier et au second potentiels de la source d'alimentation,
• une borne (50) d'entrée raccordée au câble de mesure,
• un convertisseur analogique-numérique (62) raccordé à la borne d'entrée pour convertir le signal électrique analogique présent sur la borne d'entrée en un signal numérique, et
• un microprocesseur (64) programmé pour :
∘ commander un équipement électrique en fonction de la valeur du signal numérique si cette valeur numérique correspond à une valeur du signal électrique analogique comprise dans une plage prédéterminée de mesure et, en alternance,
∘ signaler l'état coupé du premier câble d'alimentation si la valeur du signal numérique correspond à une première valeur de défaut prédéterminée située en dehors de toute plage prédéterminée de mesure,
- un module (38; 150) de surveillance interposé entre les bornes d'alimentation du capteur et les premier et second câbles d'alimentation, ce module de surveillance étant apte à générer sur le câble de mesure la première valeur de défaut en réponse à la coupure du premier câble d'alimentation,
**caractérisée en ce que** le module (38) de surveillance comporte un premier transistor (Q3) comportant une première et une seconde électrodes de puissance et une électrode de commande, ce premier transistor étant apte à commuter, en fonction du signal de commande reçu sur son électrode de commande, entre :
• un état ouvert où ses électrodes de puissance sont électriquement isolées l'une de l'autre, et
• un état fermé où ses électrodes de puissance sont électriquement raccordées l'une à l'autre,
la première et la seconde électrodes de puissance du premier transistor étant électriquement raccordées, respectivement, au second câble (24) d'alimentation et au câble (20) de mesure de sorte que, lorsque le premier transistor est dans son état fermé, la première valeur de défaut est générée sur le câble de mesure, et
l'électrode de commande du premier transistor étant raccordée au premier câble (22) d'alimentation de manière à ce que la disparition du premier potentiel sur le premier câble d'alimentation, provoquée par sa coupure, déclenche automatiquement la commutation du premier transistor (Q3) vers son état fermé et que, en alternance, l'absence de coupure du premier câble d'alimentation maintienne le premier transistor dans son état ouvert.

2. Installation selon la revendication 1, dans laquelle :
- le microprocesseur (64) est également programmé pour signaler l'état coupé du second câble d'alimentation si la valeur du signal numérique correspond à une deuxième valeur de défaut prédéterminée, cette deuxième valeur de défaut étant différente de la première valeur de défaut et située en dehors de toute plage prédéterminée de mesure, et
- le module de surveillance comporte un deuxième transistor (Q1) comportant une première et une seconde électrodes de puissance et une électrode de commande, ce deuxième transistor étant apte à commuter, en fonction du signal de commande reçu sur son électrode de commande, entre :
• un état ouvert où ses électrodes de puissance sont électriquement isolées l'une de l'autre, et
• un état fermé où ses électrodes de puissance sont électriquement raccordées l'une à l'autre,
la première et la seconde électrodes de puissance étant électriquement raccordées, respectivement, au premier câble (22) d'alimentation et au câble (20) de mesure de sorte que, lorsque le deuxième transistor (Q1) est dans son état fermé, la deuxième valeur de défaut prédéterminée est générée sur le câble de mesure,
l'électrode de commande du deuxième transistor (Q1) est raccordée au second câble (24) d'alimentation de manière à ce que la disparition du second potentiel sur le second câble d'alimentation, provoquée par sa coupure, déclenche automatiquement la commutation du deuxième transistor vers son état fermé et que, en alternance, l'absence de coupure du second câble d'alimentation maintienne le deuxième transistor dans son état ouvert.

3. Installation selon la revendication 1, dans laquelle le module (150; 200) de surveillance comporte :
- une première branche raccordée entre les première et seconde bornes (82, 84) d'alimentation du capteur (40), cette première branche comportant un troisième transistor (Q4) dont les électrodes de puissance sont raccordées en série avec une première résistance (R20), l'électrode de commande du premier transistor (Q3; Q3') étant raccordée entre cette première résistance et ce troisième transistor,
- un pont de résistances raccordé entre les première et seconde bornes (82, 84) d'alimentation du capteur (40), ce pont comportant au moins deux résistances (R22, R23) raccordées en série et l'électrode de commande du troisième transistor (Q4) étant raccordée entre ces deux résistances du pont de résistances.

4. Installation selon la revendication 2, dans laquelle le module (150; 200) de surveillance comporte :
- une seconde branche raccordée entre les première et seconde bornes (82, 84) d'alimentation du capteur (40), cette seconde branche comportant un quatrième transistor (Q2) dont les électrodes de puissance sont raccordées en série avec une deuxième résistance (R21), l'électrode de commande du deuxième transistor (Q1; Q1') étant raccordée entre cette deuxième résistance et ce quatrième transistor,
- un pont de résistances raccordé entre les première et seconde bornes (82, 84) d'alimentation du capteur (40), ce pont comportant au moins deux résistances (R23, R24) raccordées en série et l'électrode de commande du quatrième transistor (Q2) étant raccordée entre ces deux résistances du pont de résistances.

5. Installation selon la revendication 3, dans laquelle l'électrode de commande du premier transistor (Q3') est raccordée entre la première résistance (R20) et le troisième transistor (Q4) par l'intermédiaire d'un étage inverseur (204), cette étage inverseur comportant un cinquième transistor (Q6) et une résistance (R26), ce cinquième transistor (Q6) comportant :
• une électrode de puissance raccordée au câble (20) de mesure par l'intermédiaire de la résistance (R26) de l'étage inverseur (204),
• une autre électrode de puissance raccordée au second câble (24) d'alimentation, et
• une électrode de commande raccordée entre la première résistance (R20) et le troisième transistor (Q4),
l'électrode de commande du premier transistor (Q3') étant raccordée entre le cinquième transistor (Q6) et la résistance (R26) de l'étage inverseur (204).

6. Installation selon la revendication 1 ou 2, dans laquelle :
- le calculateur électronique (12) comporte :
• une troisième résistance (R1) raccordée entre sa première borne d'alimentation et sa borne d'entrée,
• une quatrième résistance (R2, R3) raccordée entre sa borne d'entrée et sa seconde borne d'alimentation,
- le module (38) de surveillance comporte :
• une cinquième résistance (R4) raccordée entre le premier câble (22) d'alimentation et un point milieu (86) électriquement isolé du câble (20) de mesure,
• une sixième résistance (R5) raccordée entre le point milieu (86) et le second câble (24) d'alimentation, et
- l'électrode de commande du premier transistor (Q3) et/ou du deuxième transistor (Q1) est raccordée au point milieu (86) sans passer par l'intermédiaire des cinquième et sixième résistances (R4, R5) de manière à générer un signal qui déclenche la commutation du premier transistor (Q3) en réponse à la disparition du premier potentiel sur le premier câble (22) d'alimentation et qui déclenche la commutation du deuxième transistor (Q1) en réponse à la disparition du second potentiel sur le second câble (24) d'alimentation.

7. Installation selon l'une quelconque des revendications précédentes, dans laquelle les électrodes de puissance du premier transistor (Q3) sont raccordées en série avec une première diode (D2) qui interdit la circulation d'un courant depuis le second câble (24) d'alimentation vers le câble (20) de mesure.

8. Installation selon la revendication 2, dans laquelle les électrodes de puissance du deuxième transistor (Q1) sont raccordées en série avec une seconde diode (D1) qui interdit la circulation d'un courant depuis le câble (20) de mesure vers le premier câble (22) d'alimentation.

9. Installation selon l'une quelconque des revendications précédentes, dans laquelle :
- le calculateur électronique (12) comporte :
• une troisième résistance (R1) raccordée entre sa première borne (52) d'alimentation et sa borne (50) d'entrée,
• une quatrième résistance (R2, R3) raccordée entre sa borne d'entrée et sa seconde borne (54) d'alimentation,
- les valeurs des troisième et quatrième résistances (R1, R2, R3) sont telles que, lorsque le câble (20) de mesure est coupé, le signal électrique analogique au niveau de la borne (50) d'entrée du calculateur électronique prend une troisième valeur de défaut prédéterminée, cette troisième valeur de défaut étant différente des première et deuxième valeurs de défaut et située en dehors de toute plage prédéterminée de mesure, et
- le microprocesseur (64) est également programmé pour signaler l'état coupé du câble (20) de mesure si la valeur du signal numérique correspond à la troisième valeur de défaut.

10. Installation selon l'une quelconque des revendications précédentes, dans laquelle le ou les transistors du module de surveillance sont des transistors bipolaires.

11. Installation selon l'une quelconque des revendications précédentes, dans laquelle lorsque le premier potentiel est supérieur au second potentiel, le premier transistor (Q3) est un transistor PNP, et lorsque le premier potentiel est inférieur au second potentiel, le premier transistor est un transistor NPN.

12. Aéronef (2) comportant une installation électrique (4) selon l'une quelconque des revendications précédentes.

13. Module de surveillance pour la réalisation d'une installation électrique selon l'une quelconque des revendication 1 à 11, ce module de surveillance étant apte à être interposé entre les bornes d'alimentation du capteur et les premier et second câbles d'alimentation, ce module de surveillance étant apte à générer sur le câble de mesure la première valeur de défaut en réponse à la coupure du premier câble d'alimentation,
**caractérisé en ce que**
- le module de surveillance comporte un premier transistor (Q3) comportant une première et une seconde électrodes de puissance et une électrode de commande, ce premier transistor étant apte à commuter, en fonction du signal de commande reçu sur son électrode de commande, entre :
• un état ouvert où ses électrodes de puissance sont électriquement isolées l'une de l'autre, et
• un état fermé où ses électrodes de puissance sont électriquement raccordées l'une à l'autre,
- la première et la seconde électrodes de puissance du premier transistor étant électriquement raccordées, respectivement, au second câble (24) d'alimentation et au câble (20) de mesure de sorte que, lorsque le premier transistor est dans son état fermé, la première valeur de défaut est générée sur le câble de mesure, et
- l'électrode de commande du premier transistor étant raccordée au premier câble (22) d'alimentation de manière à ce que la disparition du premier potentiel sur le premier câble d'alimentation, provoquée par sa coupure, déclenche automatiquement la commutation du premier transistor (Q3) vers son état fermé et que, en alternance, l'absence de coupure du premier câble d'alimentation maintienne le premier transistor dans son état ouvert.

## Patentansprüche

1. Elektrische Anlage, die aufweist:
- ein erstes und ein zweites Versorgungskabel (22, 24), die an ein erstes bzw. ein zweites unterschiedliches Potential einer Versorgungsquelle angeschlossen sind,
- ein Messkabel (20), wobei das erste und das zweite Versorgungskabel und das Messkabel im Inneren eines oder mehrerer Kabelbäume (26) untergebracht sind,
- einen Sensor (40), der geeignet ist, eine physikalische Größe zu messen, wobei dieser Sensor aufweist:
• eine erste und eine zweite Versorgungsklemme (82, 84), die an das erste bzw. an das zweite Versorgungskabel angeschlossen sind,
• eine an das Messkabel angeschlossene Ausgangsklemme (80), und
• einen Wandler (90), der mittels der ersten und zweiten Versorgungsklemmen des Sensors versorgt wird, wobei dieser Wandler geeignet ist, die gemessene physikalische Größe in ein entsprechendes elektrisches Signal umzuwandeln, und
• der Sensor geeignet ist, an seiner Ausgangsklemme (80) ein analoges elektrisches Signal zu liefern, das die Messung der physikalischen Größe durch einen entsprechenden Wert eines Potentials oder der Stärke eines Stroms codiert, wobei der Wert des auf dem Messkabel gelieferten elektrischen Signals systematisch in einem vorbestimmten Messbereich liegt, wenn der Wandler korrekt arbeitet,
- einen elektronischen Rechner (12), der aufweist:
• eine erste und eine zweite Versorgungsklemme (52, 54), die an das erste bzw. an dass das zweite Potential der Versorgungsquelle angeschlossen sind,
• eine an das Messkabel angeschlossene Eingangsklemme (50),
• einen Analog-Digital-Wandler (62), der an die Eingangsklemme angeschlossen ist, um das an der Eingangsklemme vorhandene analoge elektrische Signal in ein digitales Signal umzuwandeln, und
• einen Mikroprozessor (64), der programmiert ist:
∘ ein elektrisches Gerät abhängig vom Wert des digitalen Signals zu steuern, wenn dieser digitale Wert einem Wert des analogen elektrischen Signals entspricht, der in einem vorbestimmten Messbereich liegt, und alternierend,
∘ den abgetrennten Zustand des ersten Versorgungskabels anzuzeigen, wenn der Wert des digitalen Signals einem ersten vorbestimmten Fehlerwert entspricht, der sich außerhalb jedes vorbestimmten Messbereichs befindet,
- ein Überwachungsmodul (38; 150), das zwischen den Versorgungsklemmen des Sensors und dem ersten und zweiten Versorgungskabel eingefügt ist, wobei dieses Überwachungsmodul geeignet ist, auf dem Messkabel als Antwort auf das Abtrennen des ersten Versorgungskabels den ersten Fehlerwert zu erzeugen,
**dadurch gekennzeichnet, dass** das Überwachungsmodul (38) einen ersten Transistor (Q3) aufweist, der eine erste und eine zweite Leistungselektrode und eine Steuerelektrode aufweist, wobei dieser erste Transistor geeignet ist, abhängig vom auf seiner Steuerelektrode empfangenen Steuersignal umzuschalten zwischen:
• einem offenen Zustand, in dem seine Leistungselektroden elektrisch voneinander isoliert sind, und
• einem geschlossenen Zustand, in dem seine Leistungselektroden elektrisch aneinander angeschlossen sind,
wobei die erste und die zweite Leistungselektrode des ersten Transistors elektrisch an das zweite Versorgungskabel (24) bzw. an das Messkabel (20) angeschlossen sind, so dass, wenn der erste Transistor in seinem geschlossenen Zustand ist, der erste Fehlerwert auf dem Messkabel erzeugt wird, und die Steuerelektrode des ersten Transistors an das erste Versorgungskabel (22) angeschlossen ist, damit das Verschwinden des ersten Potentials auf dem ersten Versorgungskabel, hervorgerufen durch sein Abtrennen, automatisch die Umschaltung des ersten Transistors (Q3) in seinen geschlossenen Zustand auslöst, und dass, alternierend, die Abwesenheit eines Abtrennens des ersten Versorgungskabels den ersten Transistor in seinem offenen Zustand hält.

2. Anlage nach Anspruch 1, wobei:
- der Mikroprozessor (64) ebenfalls programmiert ist, den abgetrennten Zustand des zweiten Versorgungskabels anzuzeigen, wenn der Wert des digitalen Signals einem zweiten vorbestimmten Fehlerwert entspricht, wobei dieser zweite Fehlerwert sich vom ersten Fehlerwert unterscheidet und sich außerhalb jedes vorbestimmten Messbereichs befindet, und
- das Überwachungsmodul einen zweiten Transistor (Q1) aufweist, der eine erste und eine zweite Leistungselektrode und eine Steuerelektrode aufweist, wobei dieser zweite Transistor geeignet ist, abhängig vom auf seiner Steuerelektrode empfangenen Steuersignal umzuschalten zwischen:
• einem offenen Zustand, in dem seine Leistungselektroden elektrisch voneinander isoliert sind, und
• einem geschlossenen Zustand, in dem seine Leistungselektroden elektrisch aneinander angeschlossen sind,
wobei die erste und die zweite Leistungselektrode an das erste Versorgungskabel (22) bzw. an das Messkabel (20) angeschlossen sind, so dass, wenn der zweite Transistor (Q1) in seinem geschlossenen Zustand ist, der zweite vorbestimmte Fehlerwert auf dem Messkabel erzeugt wird,
die Steuerelektrode des zweiten Transistors (Q1) an das zweite Versorgungskabel (24) angeschlossen ist, damit das Verschwinden des zweiten Potentials auf dem zweiten Versorgungskabel, hervorgerufen durch sein Abtrennen, automatisch das Umschalten des zweiten Transistors in seinen geschlossenen Zustand auslöst, und dass, alternierend, die Abwesenheit einer Abtrennung des zweiten Versorgungskabels den zweiten Transistor in seinem offenen Zustand hält.

3. Anlage nach Anspruch 1, wobei das Überwachungsmodul (150; 200) aufweist:
- einen ersten Zweig, der zwischen der ersten und der zweiten Versorgungsklemme (82, 84) des Sensors (40) angeschlossen ist, wobei dieser erste Zweig einen dritten Transistor (Q4) aufweist, dessen Leistungselektroden mit einem ersten Widerstand (R20) in Reihe geschaltet sind, wobei die Steuerelektrode des ersten Transistors (Q3; Q3') zwischen diesem ersten Widerstand und diesem dritten Transistor angeschlossen ist,
- eine Brücke von Widerständen, die zwischen der ersten und der zweiten Versorgungsklemme (82, 84) des Sensors (40) angeschlossen ist, wobei diese Brücke mindestens zwei in Reihe geschaltete Widerstände (R22, R23) aufweist, und die Steuerelektrode des dritten Transistors (Q4) zwischen diesen zwei Widerständen der Brücke von Widerständen angeschlossen ist.

4. Anlage nach Anspruch 2, wobei das Überwachungsmodul (150; 200) aufweist:
- einen zweiten Zweig, der zwischen der ersten und der zweiten Versorgungsklemme (82, 84) des Sensors (40) angeschlossen ist, wobei dieser zweite Zweig einen vierten Transistor (Q2) aufweist, dessen Leistungselektroden mit einem zweiten Widerstand (R21) in Reihe geschaltet sind, wobei die Steuerelektrode des zweiten Transistors (Q1; Q1') zwischen diesem zweiten Widerstand und diesem vierten Transistor angeschlossen ist,
- eine Brücke von Widerständen, die zwischen der ersten und der zweiten Versorgungsklemme (82, 84) des Sensors (40) angeschlossen ist, wobei diese Brücke mindestens zwei in Reihe geschaltete Widerstände (R23, R24) aufweist, und die Steuerelektrode des vierten Transistors (Q2) zwischen diesen zwei Widerständen der Brücke von Widerständen angeschlossen ist.

5. Anlage nach Anspruch 3, wobei die Steuerelektrode des ersten Transistors (Q3') zwischen dem ersten Widerstand (R20) und dem dritten Transistor (Q4) mittels einer Umkehrstufe (204) angeschlossen ist, wobei diese Umkehrstufe einen fünften Transistor (Q6) und einen Widerstand (R26) aufweist, wobei dieser fünfte Transistor (Q6) aufweist:
• eine an das Messkabel (20) mittels des Widerstands (R26) der Umkehrstufe (204) angeschlossene Leistungselektrode,
• eine andere an das zweite Versorgungskabel (24) angeschlossene Leistungselektrode, und
• eine zwischen dem ersten Widerstand (R20) und dem dritten Transistor (Q4) angeschlossene Steuerelektrode,
wobei die Steuerelektrode des ersten Transistors (Q3') zwischen dem fünften Transistor (Q6) und dem Widerstand (R26) der Umkehrstufe (204) angeschlossen ist.

6. Anlage nach Anspruch 1 oder 2, wobei:
- der elektronischer Rechner (12) aufweist:
• einen dritten Widerstand (R1), der zwischen seiner ersten Versorgungsklemme und seiner Eingangsklemme angeschlossen ist,
• einen vierten Widerstand (R2, R3), der zwischen seiner Eingangsklemme und seiner zweiten Versorgungsklemme angeschlossen ist,
- das Überwachungsmodul (38) aufweist:
• einen fünften Widerstand (R4), der zwischen dem ersten Versorgungskabel (22) und einem vom Messkabel (20) elektrisch isolierten Mittenpunkt (86) angeschlossen ist,
• einen sechsten Widerstand (R5), der zwischen dem Mittenpunkt (86) und dem zweiten Versorgungskabel (24) angeschlossen ist, und
- die Steuerelektrode des ersten Transistors (Q3) und/oder des zweiten Transistors (Q1) an den Mittenpunkt (86) angeschlossen ist, ohne über die fünften und sechsten Widerstände (R4, R5) zu gehen, um ein Signal zu erzeugen, das die Umschaltung des ersten Transistors (Q3) als Antwort auf das Verschwinden des ersten Potentials auf dem ersten Versorgungskabel (22) auslöst, und das die Umschaltung des zweiten Transistors (Q1) als Antwort auf das Verschwinden des zweiten Potentials auf dem zweiten Versorgungskabel (24) auslöst.

7. Anlage nach einem der vorhergehenden Ansprüche, wobei die Leistungselektroden des ersten Transistors (Q3) mit einer ersten Diode (D2) in Reihe geschaltet sind, die das Fließen eines Stroms vom zweiten Versorgungskabel (24) zum Messkabel (20) verhindert.

8. Anlage nach Anspruch 2, wobei die Leistungselektroden des zweiten Transistors (Q1) mit einer zweiten Diode (D1) in Reihe geschaltet sind, die das Fließen eines Stroms vom Messkabel (20) zum ersten Versorgungskabel (22) verhindert.

9. Anlage nach einem der vorhergehenden Ansprüche, wobei:
- der elektronische Rechner (12) aufweist:
• einen dritten Widerstand (R1), der zwischen seiner ersten Versorgungsklemme (52) und seiner Eingangsklemme (50) angeschlossen ist,
• einen vierten Widerstand (R2, R3), der zwischen seiner Eingangsklemme und seiner zweiten Versorgungsklemme (54) angeschlossen ist,
- die Werte der dritten und vierten Widerstände (R1, R2, R3) so sind, dass, wenn das Messkabel (20) abgetrennt ist, das analoge elektrische Signal im Bereich der Eingangsklemme (50) des elektronischen Rechners einen dritten vorbestimmten Fehlerwert annimmt, wobei dieser dritte Fehlerwert sich von den ersten und zweiten Fehlerwerten unterscheidet und sich außerhalb jedes vorbestimmten Messbereichs befindet, und
- der Mikroprozessor (64) ebenfalls programmiert ist, den abgetrennten Zustand des Messkabels (20) anzuzeigen, wenn der Wert des digitalen Signals dem dritten Fehlerwert entspricht.

10. Anlage nach einem der vorhergehenden Ansprüche, wobei der oder die Transistor(en) des Überwachungsmoduls bipolare Transistoren sind.

11. Anlage nach einem der vorhergehenden Ansprüche, wobei, wenn das erste Potential höher ist als das zweite Potential, der erste Transistor (Q3) ein PNP-Transistor ist, und wenn das erste Potential niedriger ist als das zweite Potential, der erste Transistor ein NPN-Transistor ist.

12. Luftfahrzeug (2), das eine elektrische Anlage (4) nach einem der vorhergehenden Ansprüche aufweist.

13. Überwachungsmodul zur Herstellung einer elektrischen Anlage nach einem der Ansprüche 1 bis 11, wobei dieses Überwachungsmodul geeignet ist, zwischen den Versorgungsklemmen des Sensors und dem ersten und dem zweiten Versorgungskabel eingefügt zu werden, wobei dieses Überwachungsmodul geeignet ist, auf dem Messkabel den ersten Fehlerwert als Antwort auf das Abtrennen des ersten Versorgungskabels zu erzeugen,
**dadurch gekennzeichnet, dass**:
- das Überwachungsmodul einen ersten Transistor (Q3) aufweist, der eine erste und eine zweite Leistungselektrode und eine Steuerelektrode aufweist, wobei dieser erste Transistor geeignet ist, abhängig vom auf seiner Steuerelektrode empfangenen Steuersignal umzuschalten zwischen:
• einem offenen Zustand, in dem seine Leistungselektroden elektrisch voneinander isoliert sind, und
• einem geschlossenen Zustand, in dem seine Leistungselektroden elektrisch aneinander angeschlossen sind,
- wobei die erste und die zweite Leistungselektrode des ersten Transistors an das zweite Versorgungskabel (24) bzw. an das Messkabel (20) elektrisch angeschlossen sind, so dass, wenn der erste Transistor in seinem geschlossenen Zustand ist, der erste Fehlerwert auf dem Messkabel erzeugt wird, und
- wobei die Steuerelektrode des ersten Transistors an das erste Versorgungskabel (22) angeschlossen ist, damit das Verschwinden des ersten Potentials auf dem ersten Versorgungskabel, hervorgerufen durch sein Abtrennen, automatisch die Umschaltung des ersten Transistors (Q3) in seinen geschlossenen Zustand auslöst, und dass, alternierend, die Abwesenheit eines Abtrennens des ersten Versorgungskabels den ersten Transistor in seinem offenen Zustand hält.

## Claims

1. Electrical installation comprising:
- a first and a second power supply cable (22, 24) respectively connected to a first and a second different potential of a power supply source;
- a measurement cable (20), the first and second power supply cables and the measurement cable being housed inside one or more cable harnesses (26);
- a sensor (40) capable of measuring a physical quantity, this sensor comprising:
• a first and a second power supply terminal (82, 84) respectively connected to the first and to the second power supply cables;
• an output terminal (80) connected to the measurement cable; and
• a transducer (90) powered by means of the first and second power supply terminals of the sensor, this transducer being capable of converting the measured physical quantity into a corresponding electric signal; and
• the sensor is capable of delivering, on its output terminal (80), an analogue electric signal coding the measurement of the physical quantity using a corresponding value of a potential or of the magnitude of a current, the value of the electric signal delivered on the measurement cable systematically being within a predetermined measurement range when the transducer is operating correctly;
- an electronic computer (12) comprising:
• a first and a second power supply terminal (52, 54) respectively connected to the first and to the second potentials of the power supply source;
• an input terminal (50) connected to the measurement cable;
• an analogue-digital converter (62) connected to the input terminal in order to convert the analogue electric signal present on the input terminal into a digital signal; and
• a microprocessor (64) programmed to:
∘ control an item of electrical equipment as a function of the value of the digital signal if this digital value corresponds to a value of the analogue electric signal within a predetermined measurement range; and, alternatively
∘ indicate the interrupted state of the first power supply cable if the value of the digital signal corresponds to a first predetermined fault value located outside any predetermined measurement range;
- a monitoring module (38; 150) positioned between the power supply terminals of the sensor and the first and second power supply cables, this monitoring module being capable of generating, on the measurement cable, the first fault value in response to the interruption of the first power supply cable;
**characterized in that** the monitoring module (38) comprises a first transistor (Q3) comprising a first and a second power electrode and a control electrode, this first transistor being capable of switching, as a function of the control signal received on the control electrode thereof, between:
• an open state, in which the power electrodes thereof are electrically isolated from each other; and
• a closed state, in which the power electrodes thereof are electrically connected together;
the first and the second power electrodes of the first transistor being electrically connected to the second power supply cable (24) and to the measurement cable (20), respectively, so that, when the first transistor is in the closed state thereof, the first fault value is generated on the measurement cable, and the control electrode of the first transistor being connected to the first power supply cable (22), so that the loss of first potential on the first power supply cable, caused by the interruption thereof, automatically triggers switching of the first transistor (Q3) to the closed state thereof and so that, alternatively, the absence of interruption of the first power supply cable keeps the first transistor in the open state thereof.

2. Installation according to Claim 1, wherein:
- the microprocessor (64) is also programmed to indicate the interrupted state of the second power supply cable if the value of the digital signal corresponds to a second predetermined fault value, said second fault value being different from the first fault value and being outside any predetermined measurement range; and
- the monitoring module comprises a second transistor (Q1) comprising a first and a second power electrode and a control electrode, this second transistor being capable of switching, as a function of the control signal received on the control electrode thereof, between:
• an open state, in which the power electrodes thereof are electrically isolated from each other; and
• a closed state, in which the power electrodes thereof are electrically connected together;
the first and the second power electrodes being electrically connected to the first power supply cable (22) and to the measurement cable (20), respectively, so that, when the second transistor (Q1) is in the closed state thereof, the second predetermined fault value is generated on the measurement cable, the control electrode of the second transistor (Q1) is connected to the second power supply cable (24), so that the loss of second potential on the second power supply cable, caused by the interruption thereof, automatically triggers switching of the second transistor to the closed state thereof and so that, alternatively, the absence of interruption of the second power supply cable keeps the second transistor in the open state thereof.

3. Installation according to Claim 1, wherein the monitoring module (150; 200) comprises:
- a first branch connected between the first and second power supply terminals (82, 84) of the sensor (40), this first branch comprising a third transistor (Q4), the power electrodes of which are connected in series with a first resistor (R20), the control electrode of the first transistor (Q3; Q3') being connected between this first resistor and this third transistor;
- a bridge of resistors connected between the first and second power supply terminals (82, 84) of the sensor (40), this bridge comprising at least two resistors (R22, R23) connected in series and the control electrode of the third transistor (Q4) being connected between these two resistors of the bridge of resistors.

4. Installation according to Claim 2, wherein the monitoring module (150; 200) comprises:
- a second branch connected between the first and second power supply terminals (82, 84) of the sensor (40), this second branch comprising a fourth transistor (Q2), the power electrodes of which are connected in series with a second resistor (R21), the control electrode of the second transistor (Q1; Q1') being connected between this second resistor and this fourth transistor;
- a bridge of resistors connected between the first and second power supply terminals (82, 84) of the sensor (40), this bridge comprising at least two resistors (R23, R24) connected in series and the control electrode of the fourth transistor (Q2) being connected between these two resistors of the bridge of resistors.

5. Installation according to Claim 3, wherein the control electrode of the first transistor (Q3') is connected between the first resistor (R20) and the third transistor (Q4) by means of an inverter stage (204), this inverter stage comprising a fifth transistor (Q6) and a resistor (R26), this fifth transistor (Q6) comprising:
• a power electrode connected to the measurement cable (20) by means of the resistor (R26) of the inverter stage (204);
• another power electrode connected to the second power supply cable (24); and
• a control electrode connected between the first resistor (R20) and the third transistor (Q4),
the control electrode of the first transistor (Q3') being connected between the fifth transistor (Q6) and the resistor (R26) of the inverter stage (204).

6. Installation according to Claim 1 or 2, wherein:
- the electronic computer (12) comprises:
• a third resistor (R1) connected between the first power supply terminal and the input terminal thereof;
• a fourth resistor (R2, R3) connected between the input terminal and the second power supply terminal thereof;
- the monitoring module (38) comprises:
• a fifth resistor (R4) connected between the first power supply cable (22) and a central point (86) electrically isolated from the measurement cable (20);
• a sixth resistor (R5) connected between the central point (86) and the second power supply cable (24); and
- the control electrode of the first transistor (Q3) and/or of the second transistor (Q1) is connected to the central point (86) without passing via the fifth and sixth resistors (R4, R5) so as to generate a signal which triggers switching of the first transistor (Q3) in response to the loss of first potential on the first power supply cable (22) and which triggers switching of the second transistor (Q1) in response to the loss of second potential on the second power supply cable (24).

7. Installation according to any one of the preceding claims, wherein the power electrodes of the first transistor (Q3) are connected in series with a first diode (D2) that prevents the flow of a current from the second power supply cable (24) to the measurement cable (20).

8. Installation according to Claim 2, wherein the power electrodes of the second transistor (Q1) are connected in series with a second diode (D1) that prevents the flow of a current from the measurement cable (20) to the first power supply cable (22).

9. Installation according to any one of the preceding claims, wherein:
- the electronic computer (12) comprises:
• a third resistor (R1) connected between the first power supply terminal (52) and the input terminal (50) thereof;
• a fourth resistor (R2, R3) connected between the input terminal and the second power supply terminal (54) thereof;
- the values of the third and fourth resistors (R1, R2, R3) are such that, when the measurement cable (20) is interrupted, the analogue electric signal at the input terminal (50) of the electronic computer assumes a third predetermined fault value, this third fault value being different from the first and second fault values and being outside any predetermined measurement range; and
- the microprocessor (64) is also programmed to indicate the interrupted state of the measurement cable (20) if the value of the digital signal corresponds to the third fault value.

10. Installation according to any one of the preceding claims, wherein the transistor(s) of the monitoring module are bipolar transistors.

11. Installation according to any one of the preceding claims, wherein, when the first potential is greater than the second potential, the first transistor (Q3) is a PNP transistor and, when the first potential is less than the second potential, the first transistor is an NPN transistor.

12. Aircraft (2) comprising an electrical installation (4) according to any one of the preceding claims.

13. Monitoring module for completing an electrical installation according to any one of Claims 1 to 11, this monitoring module being capable of being positioned between the power supply terminals of the sensor and the first and second power supply cables, this monitoring module being capable of generating, on the measurement cable, the first fault value in response to the interruption of the first power supply cable,
**characterized in that**
- the monitoring module comprises a first transistor (Q3) comprising a first and a second power electrode and a control electrode, this first transistor being capable of switching, as a function of the control signal received on the control electrode thereof, between:
• an open state, in which the power electrodes thereof are electrically isolated from each other; and
• a closed state, in which the power electrodes thereof are electrically connected together;
- the first and the second power electrodes of the first transistor being electrically connected to the second power supply cable (24) and to the measurement cable (20), respectively, so that, when the first transistor is in the closed state thereof, the first fault value is generated on the measurement cable, and
- the control electrode of the first transistor being connected to the first power supply cable (22), so that the loss of first potential on the first power supply cable, caused by the interruption thereof, automatically triggers switching of the first transistor (Q3) to the closed state thereof and so that, alternatively, the absence of interruption of the first power supply cable keeps the first transistor in the open state thereof.
